# EUROPÄISCHE PATENTSCHRIFT

(11) **EP 1 559 195 B1**
(45) Veröffentlichungstag und Bekanntmachung des Hinweises auf die Patenterteilung: **09.01.2008**
(21) Anmeldenummer: 03809728.3
(22) Anmeldetag: 22.10.2003
(51) Int. Cl.: H03K 17/96

(54) **KAPAZITIVER ANNÄHERUNGS- UND/ODER BERÜHRUNGSSENSOR SOWIE ELEKTRISCH LEITFÄHIGER KUNSTSTOFFKÖRPER FÜR EINEN SOLCHEN SENSOR**
CAPACITIVE PROXIMITY SENSOR AND/OR CONTACT SENSOR, AND ELECTRICALLY CONDUCTIVE PLASTIC MEMBER FOR SUCH A SENSOR
DETECTEUR CAPACITIF D'APPROCHE ET/OU DE CONTACT ET CORPS EN PLASTIQUE ELECTRIQUEMENT CONDUCTEUR POUR UN DETECTEUR DE CE TYPE

(30) Priorität: 29.10.2002 DE 10250395
(43) Veröffentlichungstag der Anmeldung: 03.08.2005
(73) Patentinhaber: BSH Bosch und Siemens Hausgeräte GmbH, 81739 München (DE)
(72) Erfinder: ADAM, Paul, 93161 Sinzing (DE); GRAUVOGL, Erwin, 93161 Sinzing (DE); PUCHTA, Ralf, 93053 Regensburg (DE); SAMS, Walter, 93138 Lappersdorf (DE)
(86) Internationale Anmeldenummer: PCT/EP2003/011714
(87) Internationale Veröffentlichungsnummer: WO 2004/040762

(56) Entgegenhaltungen:
- EP-A- 0 859 467
- EP-A- 1 018 787
- EP-A- 1 061 608
- US-A- 4 380 007
- US-A- 5 973 417
- US-B1- 6 265 682

## Beschreibung

Die Erfindung bezieht sich auf einen kapazitiven Annäherungs- und/oder Berührungssensor mit einem elektrisch leitfähigen Kunststoffkörper, der zwischen einem Unterseitenbereich einer elektrisch isolierenden Abdeckplatte und einer in Abstand von dieser angeordneten elektrisch leitenden Kontaktfläche einer Trägerplatte angeordnet ist, die in ihrer Lage relativ zu der genannten Abdeckplatte festliegt und deren Kontaktfläche mit einer Auswerteschaltung verbindbar ist, durch welche eine Kapazitätsänderung eines die betreffende Abdeckplatte, den Kunststoffkörper und die genannte Kontaktfläche umfassenden Kondensators infolge einer Annäherung und/oder Berührung eines dem genannten Unterseitenbereich gegenüberliegenden Annäherungs- bzw. Berührungsbereiches der Abdeckplatte durch ein bzw. mit einem Element, welches ein vom Potenzial der Kontaktfläche verschiedenes Potenzial, insbesondere Erdpotenzial führt, feststellbar und auswertbar ist.

Die Erfindung bezieht sich außerdem auf einen elektrisch leitfähigen Kunststoffkörper für einen kapazitiven Annäherungs- und/oder Berührungssensor.

Ein kapazitiver Sensor der eingangs bezeichneten Art ist in Form eines Annäherungsschalters seit langem bekannt (DE 35 19 495 A1). Der betreffende bekannte Annäherungsschalter weist eine kapazitive Sonde mit einer metallischen Stütze auf, die mit einer Auswerteschaltung verbunden ist und zwischen der und einer als Dielektrikum dienenden Abdeckplatte aus einem elektrisch isolierenden Material, wie Glas, eine Schicht aus leitendem Schaumstoff angeordnet ist. Die Anordnung ist dabei so getroffen, dass sich die genannte Schaumstoffschicht aufgrund ihrer Elastizität an die Abdeckplatte anschmiegt, ohne dass dazwischen ein Luftspalt verbleibt. Damit wird die Schaumstoffschicht zwischen der Abdeckplatte und der metallischen Stütze also unter einem gewissem Druck gehalten. Wie die betreffende Schaumstoffschicht zwischen der erwähnten Trägerplatte und der genannten Abdeckplatte sowohl bei der Montage als auch im Betrieb in ihrer Lage relativ zu den betreffenden Platten stabil gehalten werden kann, ist in dem betrachteten Zusammenhang allerdings nicht bekannt.

Es ist auch schon eine kapazitive Tastaturanordnung bekannt (US-5.087.825-A), die ein Substrat enthält, welches eine Vielzahl von darauf angebrachten elektrisch leitenden Plattengliedern aufweist, die voneinander isoliert sind. Die betreffenden Plattenglieder sind von einem im wesentlichen festen dielektrischen Glied überlagert, das eine den Plattengliedern zugewandte Seite aufweist. Außerdem ist eine Vielzahl von elektrisch leitenden Übertragungsgliedern vorgesehen, deren jedes aus einem kompressiblen leitenden Polymer besteht und sich zwischen dem dielektrischen Glied und einem der genannten Plattenglieder erstreckt, um eine luftdichte Berührungsfläche mit dem betreffenden dielektrischen Glied und mit dem zugehörigen einen Plattenglied der genannten Plattenglieder herzustellen. Mit den betreffenden Plattengliedern ist schließlich eine Schaltungsanordnung verbunden, die auf die Kapazität zwischen den betreffenden Plattengliedern und Erde bzw. Masse anspricht, um ein für eine Kapazitätsänderung zwischen zumindest einem der betreffenden Plattenglieder und Erde bzw. Masse kennzeichnendes Signal zu erzeugen. Damit wird bei dieser bekannten kapazitiven Tastaturanordnung das gleiche Sensorprinzip angewandt, wie es bereits bei dem oben betrachteten bekannten Annäherungsschalter genutzt wird. Anstelle der bei dem betreffenden bekannten Annäherungsschalter verwendeten elektrisch leitenden Schaumstoffschicht wird bei der gerade betrachteten bekannten kapazitiven Tastaturanordnung jedoch ein kompressibles leitendes Polymer verwendet. Bezüglich der aus einem kompressiblen leitenden Polymer bestehenden Übertragungsglieder ist in dem betrachteten Zusammenhang lediglich bekannt, dass diese zwischen dem dielektrischen Glied und den Plattengliedern eingeschichtet sind. Eine solche Montage stellt jedoch in der Regel keine langfristig stabile Anordnung derartiger Übertragungsglieder sicher. Je nach Anwendung ist mit einer Verschiebung der betreffenden Übertragungsglieder und damit mit einer nicht mehr zufriedenstellenden Arbeitsweise der diese enthaltenden Tastaturanordnung zu rechnen.

Es ist ferner ein Berührungsschalter mit einer Sensortaste bekannt (EP 0 859 467 B1), der nach dem gleichen Prinzip arbeitet wie der eingangs genannte kapazitive Annäherungsschalter. Anstelle der bei dem betreffenden bekannten Annäherungsschalter verwendeten elektrisch leitenden Schaumstoffschicht wird hier jedoch ein Kunststoffkörper aus leitfähigem Kunststoff- oder Gummimaterial und gegebenenfalls aus Silikon verwendet und die jeweilige ortsfeste Montage des betreffenden Kunststoffkörpers wird dadurch sichergestellt, dass entweder der betreffende Kunststoffkörper auf der zugehörigen Kontaktfläche und/oder der Abdeckplatte mittels eines leitfähigen Klebers oder Doppelklebebandes aufgebracht und/oder auf einen Befestigungsstift aufgesteckt wird. Dies bedingt jedoch die Ausführung zusätzlicher Arbeitsschritte, die jedoch zu vermeiden bei der Montage höchst erwünscht ist.

Der Erfindung liegt daher die Aufgabe zugrunde, einen Weg zu zeigen, wie bei einem relativ einfach herzustellenden kapazitiven Annäherungs- und/oder Berührungssensor der eingangs genannten Art auf besonders einfache Weise eine stabile und sichere Befestigung des Kunststoffkörpers zwischen der isolierenden Abdeckplatte und der zugehörigen Kontaktfläche sichergestellt werden kann.

Gelöst wird die vorstehend aufgezeigte Aufgabe bei einem kapazitiven Annäherungs- und/oder Berührungssensor der eingangs genannten Art erfindungsgemäß dadurch, dass der Kunststoffkörper als Steck- und/oder Klemmteil ausgebildet ist und durch Ein- oder Aufstecken in die oder durch Klemmen an der Trägerplatte mit dieser und damit mit der Kontaktfläche kraft- und/oder formschlüssig verbunden ist.

Die Erfindung bringt den Vorteil mit sich, dass auf besonders einfache Weise der Kunststoffkörper in seiner Lage zwischen der elektrisch isolierenden Abdeckplatte und der zugehörigen elektrisch leitenden Kontaktfläche der Trägerplatte stets unveränderlich festgelegt ist, ohne dass es dazu gesonderter Arbeitsschritte, wie der Aufbringung von Klebstoff oder eines Klebbandes und/oder eines Befestigungsstiftes bedarf. Allein durch Ein- und Aufstecken oder durch Klemmen des als Steck- und/oder Klemmteil ausgebildeten Kunststoffkörpers auf die bzw. an der Trägerplatte mit der zugehörigen Kontaktfläche und der damit verbundenen kraft- und/oder formschlüssigen Verbindung zwischen dem Kunststoffkörper und der betreffenden Kontaktfläche bzw. der diese aufweisenden Trägerplatte ist die gewünschte ortsfeste Anordnung des Kunststoffkörpers zwischen der genannten Abdeckplatte und der zugehörigen Kontaktfläche der Trägerplatte stets sichergestellt. Damit ist ein relativ einfach herzustellender und hinsichtlich seiner Funktion sicherer kapazitiver Annäherungs- und/oder Berührungssensor geschaffen.

Vorzugsweise weist der als Steckteil ausgebildete Kunststoffkörper an seinem Steckende einen zapfenförmigen Einsteckdorn auf, der in eine entsprechend geformte Aufnahmeöffnung der Kontaktfläche und der Trägerplatte eingedrückt oder eingeschoben ist, oder er weist in seiner in Steckrichtung verlaufenden Außenseite wenigstens einen sich in dieser Steckrichtung erstreckenden Aufnahmeschlitz auf, in welchem die Trägerplatte mit der Kontaktfläche aufgenommen ist. Hierdurch ergibt sich der Vorteil eines besonders geringen konstruktiven Aufwands für den als Steckteil ausgebildeten Kunststoffkörper.

Zweckmäßigerweise weist der als Steckteil ausgebildete Kunststoffkörper in seiner in Steckrichtung verlaufenden Außenseite zwei diametral gegenüberliegende Aufnahmeschlitze auf, in welchen die Trägerplatte mit ihrer Kontaktfläche aufgenommen ist. Hierdurch läßt sich in vorteilhafter Weise eine besonders gute Positionierung des als Steckteil ausgebildeten Kunststoffkörpers sicherstellen.

Gemäß einer anderen zweckmäßigen Weiterbildung der Erfindung weist der als Klemmteil ausgebildete Kunststoffkörper wenigstens einen Klemmschlitz auf, von dem die Trägerplatte mit ihrer Kontaktfläche aufgenommen ist. Hierdurch ergibt sich der Vorteil, dass der Kunststoffkörper auf besonders einfache Weise als Klemmteil zur Verfügung gestellt und in einer sicheren Position auf der Kontaktfläche der Trägerplatte gehalten werden kann.

Zweckmäßigerweise weist der Kunststoffkörper im Bereich zwischen seiner Anlage an dem Unterseitenbereich der Abdeckplatte und der Kontaktfläche der Trägerplatte entweder einen mehreckigen, insbesondere viereckigen Querschnitt oder einen runden Querschnitt auf. Derart geformte Kunststoffkörper lassen sich in vorteilhafter Weise besonders einfach herstellen.

Vorzugsweise ist der Kunststoffkörper durch ein Stanz-, Spritz-, Guss- oder Strangpressteil gebildet. Dies bringt den Vorteil mit sich, dass der Kunststoffkörper durch einfache Herstellungsschritte hergestellt werden kann.

Zur Steigerung der Elastizität des Kunststoffkörpers ist in diesem zweckmäßigerweise wenigstens ein Hohlraum gebildet. Der betreffende Hohlraum kann z.B. durch wenigstens eine Bohrung bzw. ein Loch oder eine Schlitzung hervorgerufen sein.

Von Vorteil ist es ferner, den Kunststoffkörper aus elektrisch leitfähigem Silikon zu bilden. Er ist damit besonders gut für den Einsatz in Umgebungen mit höheren Temperaturen geeignet, wie sie insbesondere in Elektrokochgeräten auftreten, in denen kapazitive Annäherungs- und/oder Berührungssensoren für verschiedene Einstell- und Steuerungsvorgänge eingesetzt werden.

Um einen kapazitiven Annäherungs- und/oder Berührungssensor gemäß der Erfindung aufzubauen stellt die vorliegende Erfindung ferner einen Kunststoffkörper bereit, der zur Anlage an einem Unterseitenbereich einer elektrisch nicht leitenden Abdeckplatte eine an den betreffenden Unterseitenbereich angepasste Oberfläche aufweist und der in seinem mit einer Kontaktfläche einer Trägerplatte zu verbindenden Bereich als Steck- und/oder Klemmteil ausgebildet ist. Hierdurch ergibt sich der Vorteil eines besonders einfachen Aufbaus des Kunststoffkörpers, der außerdem einfach herstellbar ist.

Anhand von Zeichnungen werden nachstehend Ausführungsbeispiele der Erfindung näher erläutert. In den Zeichnungen zeigen
- Fig. 1: eine vergrößerte Schnittansicht eines kapazitiven Annäherungs- und/oder Berührungssensors gemäß einer ersten Ausführungsform der Erfindung,
- Fig. 2: eine Perspektivansicht eines in dem kapazitiven Annäherungs- und/oder Berührungssensor gemäß Fig. 1 enthaltenen, als Steckteil ausgebildeten Kunststoffkörpers,
- Fig. 3: eine vergrößerte Schnittansicht eines kapazitiven Annäherungs- und/oder Berührungssensors gemäß einer zweiten Ausführungsform der Erfindung,
- Fig. 4: eine Perspektivansicht eines in dem kapazitiven Annäherungs- und/oder Berührungssensor gemäß Fig. 3 enthaltenen, als Steckteil ausgebildeten Kunststoffkörpers,
- Fig. 5: eine vergrößerte Perspektivansicht zweier anderer, als Steckteile ausgebildeter Kunststoffkörper auf einer Trägerplatte für einen kapazitiven Annäherungs- und/oder Berührungssensor gemäß einer dritten Ausführungsform der Erfindung,
- Fig. 6: eine Schnittansicht längs der in Fig. 5 eingetragenen Schnittlinie VI-VI,
- Fig. 7: eine Seitenansicht eines kapazitiven Annäherungs- und/oder Berührungssensors gemäß der dritten Ausführungsform der Erfindung unter Verwendung der in Fig. 5 dargestellten Kunststoffkörper,
- Fig. 8: eine vergrößerte Schnittansicht eines kapazitiven Annäherungs- und/oder Berührungssensors gemäß einer vierten Ausführungsform der Erfindung,
- Fig. 9: eine Perspektivansicht eines in dem kapazitiven Annäherungs- und/oder Berührungssensor gemäß Fig. 8 enthaltenen, als Klemmteil ausgebildeten Kunststoffkörpers und
- Fig. 10: eine Perspektivansicht des in Fig. 9 dargestellten Kunststoffkörpers, wie er an einer Trägerplatte festgeklemmt ist.

Bevor auf die Zeichnungen näher eingegangen wird, sei angemerkt, dass einander entsprechende oder gleiche Elemente bzw. Einzelteile bei den verschiedenen Ausführungsformen des kapazitiven Annäherungs- und/oder Berührungssensors gemäß der Erfindung in sämtlichen Zeichnungsfiguren durch gleiche Bezugszeichen bezeichnet sind.

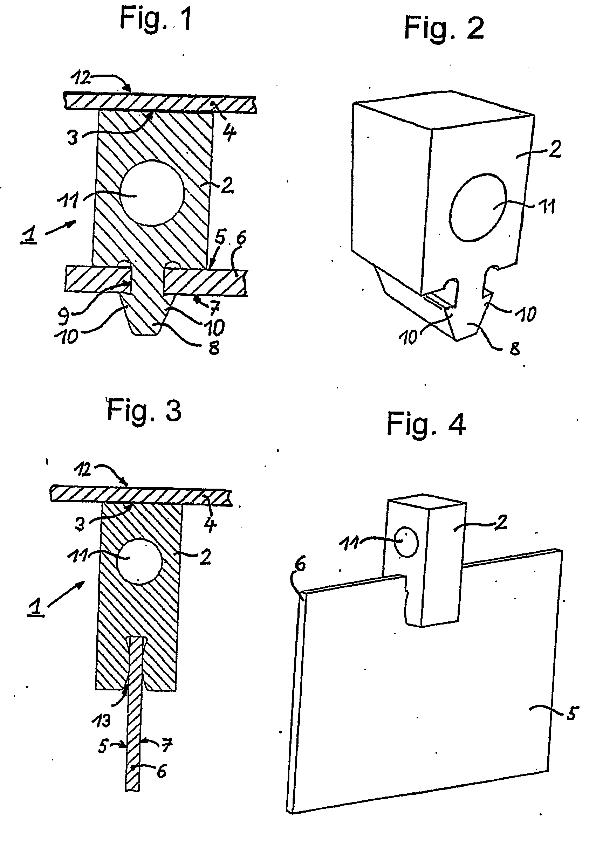

Fig. 1 zeigt in einer vergrößerten Schnittansicht einen kapazitiven Annäherungs- und/oder Berührungssensor 1 gemäß einer ersten Ausführungsform der vorliegenden Erfindung. Der betreffende Annäherungs- und/oder Berührungssensor 1 enthält einen elektrisch leitfähigen Kunststoffkörper 2, der vorzugsweise aus elektrisch leitfähigem Silikon besteht. Dieser Kunststoffkörper 2 weist in seinem oberen Bereich eine glatte Deckseite auf, die an einem glatten Unterseitenbereich 3 einer elektrisch isolierenden Abdeckplatte 4 dicht und unter Druck anliegt. In Abstand von dieser Abdeckplatte 4 und parallel dazu verlaufend ist eine Trägerplatte 6 mit einer dem Unterseitenbereich 3 zugewandten elektrisch leitenden Kontaktfläche 5 angeordnet. Die Abdeckplatte 4 und die Trägerplatte 6 liegen in ihrer relativen Lage zueinander fest. Die Trägerplatte 6 kann beispielsweise eine Leiterplatte sein, welche zusätzlich zu der erwähnten Kontaktfläche 5 auf ihrer gegenüberliegenden Plattenseite 7 ebenfalls eine Kontaktfläche aufweisen kann und welche im übrigen einseitig oder doppelseitig mit Leiterbahnen versehen sein kann.

Die Abdeckplatte 4 kann beispielsweise aus Glas oder Keramik bestehen, und die Trägerplatte 6 kann eine Kunststoffplatte sein, die auf wenigstens einer ihrer Plattenseiten die erwähnte Kontaktfläche 5 und gegebenenfalls Leiterbahnen aufweist. Bezüglich der Kontaktfläche bzw. Kontaktflächen sei hier noch angemerkt, dass mit dieser bzw. diesen eine Auswerteschaltung verbindbar ist, auf deren Aufgabe weiter unten noch näher eingegangen wird.

Der in Fig. 1 dargestellte Kunststoffkörper 2 weist in seinem unteren Bereich einen zapfenförmigen Einsteckdorn 8 auf, der in eine entsprechend geformte Aufnahmeöffnung 9 der Kontaktfläche 5 und damit der Trägerplatte 6 so eingedrückt oder eingeschoben ist, dass der betreffende Kunststoffkörper 2 zwischen seiner an der Kontaktfläche 5 anliegenden Unterseite und an der gegenüberliegenden Plattenseite 7 der Trägerplatte 6 anliegenden Zapfen 10 des Einsteckdornes 8 mit der Kontaktfläche 5 und der Plattenseite 7 und damit mit der Trägerplatte 6 kraft- und/oder formschlüssig verbunden ist. Der Kunststoffkörper 2 ist gemäß Fig. 1 somit als Steckteil oder Klemmteil ausgebildet.

Der zuvor erwähnte zapfenförmige Einsteckdorn 8 des Kunststoffkörpers 2 kann entweder ein kegelförmiger Einsteckdorn sein, oder aber er kann ein länglicher Einsteckdorn sein, wie dies die in Fig. 2 dargestellte Perspektivansicht des betreffenden Kunststoffkörpers 2 erkennen läßt.

Im Hinblick auf den in Fig. 1 und Fig. 2 gezeigten Kunststoffkörper 2 ist noch anzumerken, dass dieser im Bereich zwischen seiner Anlage an seinem Unterseitenbereich 3 der Abdeckplatte 4 und der Kontaktfläche 5 der Trägerplatte einen viereckigen Querschnitt aufweist, wie dies insbesondere aus Fig. 2 hervorgeht. Der betreffende Kunststoffkörper kann allerdings auch einen anderen mehreckigen Querschnitt oder, wie weiter unten noch ersichtlich werden wird, einen runden Querschnitt aufweisen. Außerdem weist der betreffende Kunststoffkörper 2 ein rundes Loch 11 auf, wodurch der Kunststoffkörper 2 auf Betätigungen in seiner Längsrichtung elastischer ist als in dem Fall, dass er keinerlei Öffnung bzw. Hohlraum aufweist.

Durch den in Fig. 1 gezeigten Aufbau steht somit ein kapazitiver Annäherungs- und/oder Berührungssensor zur Verfügung, der im Grunde genommen so arbeitet, wie die eingangs betrachteten bekannten kapazitiven Berührungsschalter. Wird nämlich ein Element, wie beispielsweise ein Finger, das bzw. der ein vom Potenzial der Kontaktfläche 5 der Trägerplatte 6 verschiedenes Potenzial, insbesondere Erdpotenzial führt, an den dem genannten Unterseitenbereich 3 der elektrisch isolierenden Abdeckplatte 4 gegenüberliegenden Annäherungs- bzw. Berührungsbereich 12 angenähert und/oder mit diesem in Berührung gebracht, so wird dadurch eine Kapazitätsänderung eines aus dem betreffende Element bzw. dem erwähnten Finger, der genannten Abdeckplatte, dem Kunststoffkörper und der genannten Kontaktfläche 5 bestehenden Kondensators hervorrufen, und diese Kapazitätsänderung ist mittels der bereits erwähnten, mit der betreffenden Kontaktfläche 5 verbundenen Auswerteschaltung feststellbar und auswertbar. Die betreffende Kapazitätsänderung ist dabei relativ groß, da der Kunststoffkörper mit seiner in Fig. 1 oben dargestellten Fläche vollständig an dem Unterseitenbereich 3 der elektrisch isolierenden Abdeckplatte 4 ohne einen Luftspalt fest anliegt und im Bereich der Kontaktfläche 5 mit der parallel zu der erwähnten Abdeckplatte verlaufenden Trägerplatte 6 kraft- und/oder formschlüssig verbunden ist. Eine vollflächige Auf- bzw. Anlage des Kunststoffkörpers 2 auf bzw. an der Kontaktfläche 5 und der gegebenenfalls auf der Trägerplatte n-außenseite 7 vorgesehenen Kontaktfläche ist nicht erforderlich, um dennoch die gewünschte Funktion des kapazitiven Annäherungs- und/oder Berührungssensors 1 zu gewährleisten.

In Fig. 3 ist eine vergrößerte Schnittansicht einer zweiten Ausführungsform des kapazitiven Annäherungs- und/oder Berührungssensors 1 gemäß der Erfindung gezeigt. Der in Fig. 3 dargestellte kapazitive Berührungssensor 1 weist einen ebenfalls als Steckteil ausgebildeten Kunststoffkörper 2 auf, der wie der Kunststoffkörper gemäß Fig. 1 und 2 ein Loch 11 aufweist, allerdings einen in seiner Steckrichtung verlaufenden Aufnahme- bzw. Klemmschlitz 13 enthält, von dem die Trägerplatte 6 mit ihrer Kontaktfläche 5 und der Plattenseite 7 kraft- und/oder formschlüssig aufgenommen ist, die ebenfalls eine Kontaktfläche aufweisen kann. Der Kunststoffkörper 2 besteht auch hier vorzugsweise aus elektrisch leitfähigem Silikon.

Im Unterschied zu dem in Fig. 1 dargestellten kapazitiven Annäherungs- und/oder Berührungssensor 1 verlaufen bei dem in Fig. 3 dargestellten kapazitiven Annäherungs- und/oder Berührungssensor 1 gemäß der Erfindung die elektrisch isolierende Abdeckplatte 4 mit ihrem Unterseitenbereich 3 und ihrem Annäherungs- bzw. Berührungsbereich 12 und die Trägerplatte 6 nicht parallel zueinander, sondern sie stehen rechtwinklig zueinander; hinsichtlich ihrer relativen Lage zueinander liegen die Abdeckplatte 4 und die Trägerplatte 6 jedoch auch hier fest. Im übrigen liegt der Kunststoffkörper 2 auch hier mit seiner Oberseite fest, das heißt ohne einen Luftspalt, am Unterseitenbereich 3 der Abdeckplatte 4 an. Was die Funktionsweise dieses kapazitiven Annäherungs- und/oder Berührungssensors 1 anbelangt, so liegen dieselben Verhältnisse vor, wie sie im Zusammenhang mit dem in Fig. 1 dargestellten kapazitiven Annäherungs- und/oder Berührungssensor 1 erläutert worden sind.

Fig. 4 zeigt in einer Perspektivansichfden in Fig. 3 dargestellten, als Steckteil ausgebildeten Kunststoffkörper 2, wie er auf der Trägerplatte 6 aufgesteckt ist, von der in Fig. 4 lediglich die Kontaktfläche 5 gezeigt ist. Es dürfte einzusehen sein, dass die Trägerplatte 6 grundsätzlich mit nur einer Kontaktfläche 5 für die Herstellung einer elektrisch leitenden Verbindung mit dem Kunststoffkörper 2 auskommt. Es kann jedoch zweckmäßig sein, auf der der Kontaktfläche 5 gegenüberliegenden Plattenseite 7 ebenfalls eine elektrisch leitende Kontaktfläche vorzusehen. Dadurch läßt sich die Berührungsfläche zwischen dem Aufnahme- bzw. Klemmschlitz 13 des Kunststoffkörpers 2 und den Kontaktflächen erhöhen.

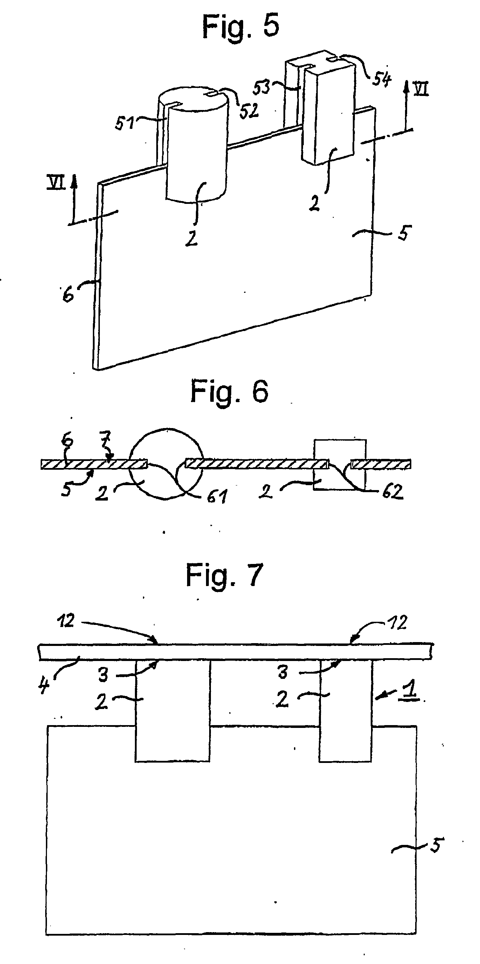

Fig. 5 zeigt in einer ähnlichen Perspektivansicht wie Fig. 4 eine weitere Modifikation der für einen kapazitiven Annäherungs- und/oder Berührungssensor gemäß einer dritten Ausführungsform der Erfindung verwendbaren Kunststoffkörper 2, die ebenfalls vorzugsweise aus elektrisch leitfähigem Silikon bestehen. Im Unterschied zu dem in Fig. 3 und 4 dargestellten Kunststoffkörper 2 weisen die in Fig. 5 dargestellten, jeweils als Steckteil ausgebildeten Kunststoffkörper 2 in ihrer in Steckrichtung verlaufenden Außenseite jeweils zwei diametral gegenüberliegende Aufnahmeschlitze 51, 52 bzw. 53, 54 auf, in welchen die Trägerplatte 6 mit ihrer Kontaktfläche 5 aufgenommen ist.

Wie aus der in Fig. 6 gezeigten Schnittansicht längs der in Fig. 5 eingetragenen Schnittlinie VI-VI hervorgeht, sind die beiden elektrisch leitfähigen Kunststoffkörper 2 mit ihren diametral gegenüberliegenden Aufnahmeschlitzen 51, 52 bzw. 53, 54 von entsprechend dimensionierten Schlitzen 61 bzw. 62 der Trägerplatte 6 aufgenommen. In diesem Zusammenhang sei angemerkt, dass die Trägerplatte 6 nicht nur auf ihrer mit 5 bezeichneten Außenseite als Kontaktfläche ausgebildet sein kann, sondern dass auch die dazu gegenüberliegende andere Außenseite 7 ebenfalls als Kontaktfläche ausgebildet sein kann.

Fig. 7 zeigt in einer Seitenansicht die erwähnte dritte Ausführungsform des kapazitiven Annäherungs- und/oder Berührungssensors 1 gemäß der Erfindung mit der in Fig. 5 dargestellten Anordnung mit den von der Trägerplatte 6 aufgenommenen beiden Kunststoffkörpern 2 und der in Abstand von der Trägerplatte 6 auf den Kunststoffkörpern 2 liegenden elektrisch isolierenden Abdeckplatte 4 mit ihren Unterseitenbereichen 3 und ihren Annäherungs- bzw. Berührungsbereichen 12. Mit ihren Oberseiten liegent die Kunststoffkörper 2 fest, das heißt ohne Luftspalte, an den Unterseitenbereichen 3 der Abdeckplatte 4 an. Auch hier befinden sich die Trägerplatte 6 und die Abdeckplatte 4 in einer festen relativen Lage zueinander. Hinsichtlich der Funktion des so gebildeten kapazitiven Annäherungs- und/oder Berührungssensors 1 liegen dieselben Verhältnisse vor, wie sie im Zusammenhang mit dem in Fig. 1 dargestellten kapazitiven Annäherungs- und/oder Berührungssensor 1 erläutert worden sind.

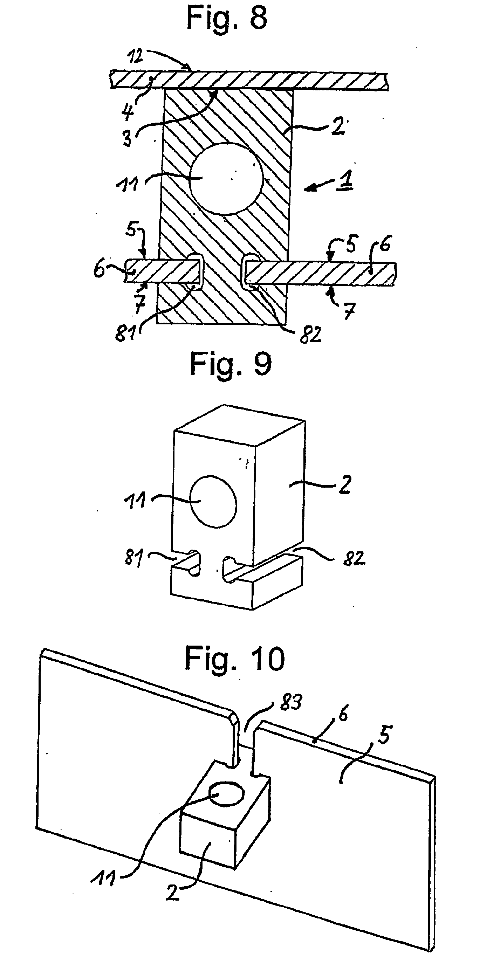

In Fig. 8 ist in einer vergrößerten Seitenschnittansicht ein kapazitiver Annäherungs- und/oder Berührungssensor 1 gemäß einer vierten Ausführungsform der Erfindung dargestellt. Im Unterschied zu den vorstehend betrachteten Ausführungsbeispielen des kapazitiven Annäherungs- und/oder Berührungssensors gemäß der Erfindung zeigt Fig. 8 einen als Klemmteil ausgebildeten elektrisch leitfähigen Kunststoffkörper 2, der zwei Klemmschlitze 81, 82 aufweist, die von der Trägerplatte 6 aufgenommen und dabei auf deren Kontaktfläche 5 und auf deren Außenseite 7, die gegebenenfalls ebenfalls eine Kontaktfläche ist, geklemmt sind. Die Anordnung der betreffenden Klemmschlitze 81, 82 des elektrisch leitfähigen Kunststoffkörpers 2 sind aus der in Fig. 9 dargestellten Perspektivansicht des betreffenden Kunststoffkörpers 2 deutlicher ersichtlich. Der Kunststoffkörper 2 besteht auch hier vorzugsweise aus elektrisch leitfähigem Silikon.

Mit seiner Oberseite liegt der Kunststoffkörper 2, der ebenfalls ein Loch 11 enthält, fest, das heißt ohne einen Luftspalt, am Unterseitenbereich 3 der Abdeckplatte 4 an, und zwar wie bei allen zuvor betrachteten Ausführungsformen des kapazitiven Annäherungs- und/oder Berührungssensors gemäß der Erfindung. Ergänzend sei noch angemerkt, dass auch hier die Trägerplatte 6 und die Abdeckplatte 4 in ihrer relativen Lage zueinander festliegen und dass die Kontaktfläche 5 dem Unterseitenbereich 3 der Abdeckplatte 4 zugewandt ist.

Aus der in Fig. 10 dargestellten Perspektivansicht geht klar hervor, wie der Kunststoffkörper 2 gemäß Fig. 9 von der Trägerplatte 6 aufgenommen ist, und zwar im Bereich eines in der Trägerplatte 6 gebildeten Schlitzes 83, in den der Kunststoffkörper 2 mit seinen Klemmschlitzen 81, 82 eingeschoben und festgeklemmt ist.

An dieser Stelle sei noch angemerkt, dass grundsätzlich die anhand der Fig. 8 bis 10 erläuterte Ausführungsform eines kapazitiven Annäherungs- und/oder Berührungssensors gemäß der Erfindung mit einem elektrisch leitfähigen Kunststoffkörper 2 auskommt, der nur einen Klemmschlitz aufweist.

Die Funktionsweise der in Fig. 8 dargestellten vierten Ausführungsform eines kapazitiven Annäherungs- und/oder Berührungssensors 1 gemäß der Erfindung ist dieselbe, wie sie im Zusammenhang mit dem in Fig. 1 dargestellten kapazitiven Annäherungs- und/oder Berührungssensor erläutert worden ist.

Die bei den vorstehend erläuterten Ausführungsformen des kapazitiven Annäherungs- und/oder Berührungssensors gemäß der Erfindung verwendeten elektrisch leitfähigen Kunststoffkörper sind einfach herzustellende Kunststoffkörper, die durch Stanz-, Spritz-, Guss- oder Strangpressteile gebildet sein können. Zur Steigerung ihrer Elastizität können die betreffenden Kunststoffkörper, wie oben bereits erwähnt, mit wenigstens einem Hohlraum, wie dem oben erwähnten Loch 11 versehen sein. Hohlräume lassen sich jedoch auch in anderer Weise realisieren, beispielsweise durch Einschnitte in den jeweiligen Kunststoffkörper. Die betreffenden Kunststoffkörper weisen jeweils zur Anlage an einem Unterseitenbereich einer elektrisch nicht leitenden Abdeckplatte eine an den betreffenden Unterseitenbereich angepasste Oberfläche auf, und sie sind jeweils in ihrem mit einer Kontaktfläche einer Trägerplatte zu verbindenden Bereich als Steck- und/oder Klemmteil ausgebildet.

Wie aus der vorstehenden Beschreibung ersichtlich geworden sein dürfte, kann ein kapazitiver Annäherungs- und/oder Berührungssensor gemäß der Erfindung so aufgebaut werden, dass die die erwähnte Kontaktfläche tragende Trägerplatte entweder parallel oder senkrecht zur jeweiligen elektrisch isolierenden Abdeckplatte angeordnet ist. Dabei ist stets keine vollflächige Auflage des jeweiligen elektrisch leitfähigen Kunststoffkörpers mit der jeweiligen Kontaktfläche nötig, um dennoch die gewünschte Funktion des kapazitiven Annäherungs- und/oder Berührungssensors sicherzustellen.

Schließlich sei noch angemerkt, dass durch die vorstehend erläuterten Ausgestaltungen der elektrisch leitfähigen Kunststoffkörper und deren Aufnahme von der jeweiligen Kontaktfläche bzw. von der diese enthaltenden Trägerplatte auf relativ einfache Weise ein einstellbarer Toleranzausgleich bei der Montage der diese Kunststoffkörper und Trägerplatten enthaltenden kapazitiven Annäherungs- und/oder Berührungssensor gemäß der Erfindung möglich ist.

## Patentansprüche

1. Kapazitiver Annäherungs- und/oder Berührungssensor mit einem elektrisch leitfähigen Kunststoffkörper, der zwischen einem Unterseitenbereich einer elektrisch isolierenden Abdeckplatte und einer in Abstand von dieser angeordneten elektrisch leitenden Kontaktfläche einer Trägerplatte angeordnet ist, die in ihrer Lage relativ zu der genannten Abdeckplatte festliegt und deren Kontaktfläche mit einer Auswerteschaltung verbindbar ist, durch die eine Kapazitätsänderung eines die betreffende Abdeckplatte, den Kunststoffkörper und die genannte Kontaktfläche umfassenden Kondensators infolge einer Annäherung und/oder Berührung eines dem genannten- Unterseitenbereich gegenüberliegenden Annäherungs- bzw. Berührungsbereiches der Abdeckplatte durch ein bzw. mit einem Element, welches ein vom Potenzial der Kontaktfläche verschiedenes Potenzial, insbesondere Erdpotenzial führt, feststellbar und auswertbar ist, **dadurch gekennzeichnet, dass** der Kunststoffkörper (2) als Klemmteil ausgebildet ist und durch Klemmen an der Trägerplatte (6) mit dieser und damit mit der Kontaktfläche (5) kraftschlüssig verbunden ist, und dass der Kunststoffkörper (2) wenigstens einen Klemmschlitz (13) aufweist, von dem die Trägerplatte (6) mit der Kontaktfläche (5) aufgenommen ist.

2. Kapazitiver Annäherungs- und/oder Berührungssensor nach Anspruch 1, **dadurch gekennzeichnet, dass** der als Klemmteil ausgebildete Kunststoffkörper (2) einen in seiner Steckrichtung verlaufenden Klemmschlitz (51, 52; 53, 54) aufweist, in welchem die Trägerplatte (6) mit der Kontaktfläche (5) aufgenommen ist.

3. Kapazitiver Annäherungs- und/oder Berührungssensor nach Anspruch 1, **dadurch gekennzeichnet, dass** der als Klemmteil ausgebildete Kunststoffkörper (2) zwei Klemmschlitze (51, 52; 53, 54) aufweist, in welchen die Trägerplatte (6) mit ihrer Kontaktfläche (5) aufgenommen ist.

4. Kapazitiver Annäherungs- und/oder Berührungssensor nach einem der Ansprüche 1 bis 3, **dadurch gekennzeichnet, dass** der Kunststoffkörper (2) im Bereich zwischen seiner Anlage an dem Unterseitenbereich (3) der Abdeckplatte (4) und der Kontaktfläche (5) der Trägerplatte (6) einen mehreckigen, insbesondere viereckigen Querschnitt oder einen runden Querschnitt aufweist.

5. Kapazitiver Annäherungs- und/oder Berührungssensor nach einem der Ansprüche 1 bis 4, **dadurch gekennzeichnet, dass** der Kunststoffkörper (2) durch ein Stanz-, Spritz-, Guss- oder Strangpressteil gebildet ist.

6. Kapazitiver Annäherungs- und/oder Berührungssensor nach einem der Ansprüche 1 bis 5, **dadurch gekennzeichnet, dass** in dem Kunststoffkörper (2) wenigstens ein Hohlraum (11) gebildet ist.

7. Kapazitiver Annäherungs- und/oder Berührungssensor nach einem der Ansprüche 1 bis 6, **dadurch gekennzeichnet, dass** der Kunststoffkörper (2) aus elektrisch leitfähigem Silikon besteht.

8. Kunststoffkörper für einen kapazitiven Annäherungs- und/oder Berührungssensor nach einem der Ansprüche 1 bis 7, **dadurch gekennzeichnet, dass** er zur Anlage an einem Unterseitenbereich (3) einer elektrisch nichtleitenden Abdeckplatte (4) eine an den betreffenden Unterseitenbereich (3) angepasste Oberfläche aufweist und in seinem mit einer Kontaktfläche (5) einer Trägerplatte (6) zu verbindenden Bereich als Klemmteil ausgebildet ist.

## Claims

1. Capacitive proximity and/or contact sensor with an electrically conductive plastics material body which is arranged between an underside region of an electrically insulating cover plate and an electrically conductive surface, which is arranged at a spacing therefrom, of a carrier plate, which is fixed in its position relative to the said cover plate and the contact surface of which is connectible with an evaluating circuit, by which a change in capacitance of a capacitor, which comprises the respective cover plate, the plastics material body and the said contact surface, as a consequence of an approach to and/or contact with a proximity or contact region, which is opposite the said underside region, of the cover plate by or with an element, which conducts a potential - particularly ground potential - different from the potential of the contact surface, can be detected and evaluated, **characterised in that** the plastics material body (2) is constructed as a clamping part and is connected in force-locking manner with the carrier plate (6) by clamping thereto and thus with the contact surface (5) and that the plastics material body (2) has at least one clamping slot (13) by which the carrier plate (6) is received by the contact surface (5).

2. Capacitive proximity and/or contact sensor according to claim 1, **characterised in that** the plastics material body (2) constructed as clamping part has a clamping slot (51, 52; 53, 54) which extends in its plug direction and in which the carrier plate (6) received by the contact surface (5).

3. Capacitive proximity and/or contact sensor according to claim 1, **characterised in that** the plastics body (2) constructed as clamping part has two clamping slots (51, 52; 53, 54) in which the carrier plate (6) is received by its contact surface (5).

4. Capacitive proximity and/or contact sensor according to one of claims 1 to 3, **characterised in that** the plastics material body (2) has in the region between its contact with the underside region (3) of the cover plate (4) and the contact surface (5) of the carrier plate (6) a polygon, particularly quadrilateral, cross-section and/or a round cross-section.

5. Capacitive proximity and/or contact sensor according to one of claims 1 to 4, **characterised in that** the plastics material body (2) is formed by a stamped, injection-moulded, cast or extruded part.

6. Capacitive proximity and/or contact sensor according to one of claims 1 to 5, **characterised in that** at least one cavity (11) is formed in the plastics material body (2).

7. Capacitive proximity and/or contact sensor according to one of claims 1 to 6, **characterised in that** the plastics material body (2) consists of electrically conductive silicon.

8. Plastics material body for a capacitive proximity and/or contact sensor according to one of claims 1 to 7, **characterised in that** it has, for the contact at an underside region (3) of an electrically non-conductive cover plate (4), a surface adapted to the respective underside region (3) and is constructed in its region to be connected with a contact surface (5) of a carrier plate (6) as a clamping part.

## Revendications

1. Détecteur capacitif d'approche et/ou de contact avec un corps en plastique électriquement conducteur qui est disposé entre une zone de face inférieure d'une plaque de recouvrement électriquement isolante et une surface de contact d'une plaque porteuse électriquement conductrice disposée à distance de celle-ci, qui est fixée dans sa position relativement à la plaque de recouvrement citée et dont la surface de contact peut être reliée à un montage d'évaluation, par lequel une modification de capacité d'un condensateur comprenant la plaque de recouvrement concernée, le corps en plastique et la surface de contact citée suite à une approche et/ou un contact d'une zone d'approche resp. de contact, opposée à la zone de face inférieure citée, de la plaque de recouvrement peut être constatée et évaluée par un resp. avec un élément, qui est à un potentiel différent du potentiel de la surface de contact, notamment un potentiel terrestre, **caractérisé en ce que** le corps en plastique (2) est conçu comme une partie de serrage et est relié par l'influence d'une force par serrage sur la plaque porteuse (6) à celle-ci et ainsi à la surface de contact (5), et **en ce que** le corps en plastique (2) présente au moins une fente de serrage (13), par laquelle la plaque porteuse (6) est logée avec la surface de contact (5).

2. Détecteur capacitif d'approche et/ou de contact selon la revendication 1, **caractérisé en ce que** le corps en plastique (2) conçu comme une partie de serrage présente une fente de serrage (51, 52 ; 53, 54) s'étendant dans son sens d'insertion, dans laquelle la plaque porteuse (6) est logée avec la surface de contact (5).

3. Détecteur capacitif d'approche et/ou de contact selon la revendication 1, **caractérisé en ce que** le corps en plastique (2) conçu comme une partie de serrage présente deux fentes de serrage (51, 52 ; 53, 54), dans lesquelles est logée la plaque porteuse (6) avec sa surface de contact (5).

4. Détecteur capacitif d'approche et/ou de contact selon l'une des revendications 1 à 3, **caractérisé en ce que** le corps en plastique (2) présente dans la zone située entre son appui sur la zone de face inférieure (3) de la plaque de recouvrement (4) et la surface de contact (5) de la plaque porteuse (6) une section transversale polygonale, notamment tétragone ou une section transversale ronde.

5. Détecteur capacitif d'approche et/ou de contact selon l'une des revendications 1 à 4, **caractérisé en ce que** le corps en plastique (2) est formé par une pièce emboutie à la presse, moulée par injection, coulée ou extrudée.

6. Détecteur capacitif d'approche et/ou de contact selon l'une des revendications 1 à 5, **caractérisé en ce qu'**au moins une cavité (11) est formée dans le corps en plastique (2).

7. Détecteur capacitif d'approche et/ou de contact selon l'une des revendications 1 à 6, **caractérisé en ce que** le corps en plastique (2) se compose de silicone électriquement conductrice.

8. Corps en plastique pour un détecteur capacitif d'approche et/ou de contact selon l'une des revendications 1 à 7, **caractérisé en ce qu'**il présente pour appui sur une zone de face inférieure (3) d'une plaque de recouvrement électriquement non conductrice une surface adaptée à la zone de face inférieure concernée (3) et est conçu comme une partie de serrage dans sa zone à relier à une surface de contact (5) d'une plaque porteuse (6).
